# DEMANDE DE BREVET EUROPEEN

(11) **EP 3 426 013 A1**
(43) Date de publication de la demande: **09.01.2019**
(21) Numéro de dépôt: 18181868.3
(22) Date de dépôt: 05.07.2018
(51) Int. Cl.: H05K 7/20

(54) **DISPOSITIF DE COMMUTATION ÉLECTRIQUE ET COFFRE DE TRACTION ÉLECTRIQUE ASSOCIÉ**

(30) Priorité: 07.07.2017 FR 1756422
(71) Demandeur: ALSTOM Transport Technologies, 93400 Saint-Ouen (FR)
(72) Inventeur: VALLE, Gilles, 65430 SOUES (FR); NICOLAU, Sébastien, 65100 LOUBAJAC (FR)
(74) Mandataire: Lavoix

(57) **Abrégé**

Ce dispositif de commutation électrique (46), propre à être intégré dans un coffre de traction électrique comprenant un dispositif de refroidissement du dispositif de commutation, comprend un ensemble électrique (59) muni d'un élément de commutation électrique (66). Ce dispositif de commutation (46) comprend également une embase (61) de réception de l'ensemble électrique (59), destinée à être positionnée entre l'ensemble électrique (59) et le dispositif de refroidissement, et des moyens de mise en pression (84) de l'ensemble électrique s'étendant entre un élément de support (82) et l'embase (61) et configurés pour exercer un effort d'appui sur l'embase, propre à maintenir l'embase en appui contre le dispositif de refroidissement lorsque le dispositif de commutation est intégré dans le coffre de traction.

## Description

La présente invention concerne un dispositif de commutation électrique d'un module électrique de puissance propre à être intégré dans un coffre de traction électrique d'un véhicule de transport et un coffre de traction associé comprenant un module électrique de puissance muni du dispositif de commutation et un dispositif de refroidissement propre à refroidir le dispositif de commutation.

Le dispositif de commutation comprend un ensemble électrique muni d'un élément de commutation électrique, et un système de mise en pression de l'ensemble électrique comprenant un élément de support de l'ensemble électrique et des moyens de mise en pression de l'ensemble électrique.

L'invention s'applique au domaine du transport, en particulier du transport ferroviaire, notamment aux véhicules de transport à traction électrique, tels que les locomotives et les automotrices.

On connait du document JP 2009158632 A1 un module de puissance comprenant un dispositif de commutation équipé d'un élément de commutation propre à être maintenu en appui contre un dispositif de refroidissement à l'aide d'un système de ressort et d'un diffuseur thermique positionnée entre l'élément de commutation et le dispositif de refroidissement. Le système de ressort est configuré pour exercer un effort d'appui sur le dessus de l'élément de commutation afin de maintenir le diffuseur thermique en contact avec le dispositif de refroidissement.

Toutefois, dans un tel module de puissance, la structure du dispositif de commutation reste complexe et la performance des échanges thermiques avec le dispositif de refroidissement reste à améliorer.

La présente invention a donc pour but de proposer un dispositif de commutation d'un module électrique de puissance propre à être intégré dans un coffre de traction électrique ayant une structure simplifiée et assurant des performances améliorées d'échange thermique avec un dispositif de refroidissement associé.

A cet effet, l'invention a pour objet un dispositif de commutation du type précité comprenant une embase de réception de l'ensemble électrique, l'embase étant destinée à être positionnée entre l'ensemble électrique et le dispositif de refroidissement lorsque le dispositif de commutation est intégré dans le coffre de traction, les moyens de mise en pression s'étendant entre l'élément de support et l'embase et étant configurés pour exercer un effort d'appui sur l'embase propre à maintenir l'embase en appui contre le dispositif de refroidissement lorsque le dispositif de commutation est intégré dans le coffre de traction.

Avec le dispositif de commutation selon l'invention, le dispositif de commutation a une structure simplifiée puisque l'élément de commutation n'a pas à être configuré pour supporter l'effort d'appui directement et tout risque de déformation de l'élément de commutation est évité. En outre les moyens de mise en pression utilisés sont moins complexes et ont notamment des dimensions facilitant leur montage puisqu'ils s'étendent entre l'élément de support et l'embase.

De plus, les performances thermiques du dispositif de commutation selon l'invention sont améliorées puisque le fait que les moyens de mise en pression exercent l'effort d'appui sur l'embase permet d'améliorer la qualité du contact entre le dispositif de refroidissement et l'embase et donc les échanges thermiques entre l'élément de commutation et le dispositif de refroidissement.

Suivant d'autres aspects avantageux de l'invention, le dispositif de commutation comporte l'une ou plusieurs des caractéristiques suivantes, prises isolément ou suivant toutes les combinaisons techniquement possibles :
- le dispositif de commutation comprend un système de fixation dans le coffre de traction, le système de fixation étant propre à maintenir l'élément de support dans une position prédéterminée par rapport au dispositif de refroidissement ;
- le système de fixation est propre à fixer de manière amovible le dispositif de commutation au dispositif de refroidissement ;
- le dispositif de commutation comprend un boîtier comprenant l'ensemble électrique, le système de mise en pression et l'embase ;
- l'ensemble électrique est muni d'une unité de commande de l'élément de commutation et de moyens de liaison électrique ;
- l'élément de commutation est fixé à l'embase, et l'embase comprend autour de l'élément de commutation, de préférence de l'ensemble électrique, au moins une zone de mise en pression en contact avec les moyens de mise en pression, la zone de mise en pression s'étendant globalement parallèlement à un plan perpendiculaire à une direction de l'effort d'appui ; et
- les moyens de mise en pression sont régulièrement répartis autour de l'élément de commutation, et de préférence de l'ensemble électrique.

L'invention a également pour objet un coffre de traction électrique d'un véhicule de transport, le coffre de traction comprenant :
- un module électrique de puissance comprenant au moins un dispositif de commutation tel que décrit ci-dessus, et
- un dispositif de refroidissement propre à refroidir chaque dispositif de commutation.

Suivant d'autres aspects avantageux de l'invention, le coffre de traction comporte l'une ou plusieurs des caractéristiques suivantes, prises isolément ou suivant toutes les combinaisons techniquement admissibles :
- un matériau d'interface thermique sec, propre à améliorer le couplage thermique entre chaque embase et le dispositif de refroidissement, est positionné entre chaque embase et le dispositif de refroidissement ; et
- le dispositif de refroidissement comprend un échangeur thermique, un organe de refroidissement de chaque dispositif de commutation, l'organe de refroidissement étant en contact avec chaque embase de chaque dispositif de commutation et un circuit de refroidissement s'étendant entre l'échangeur thermique et l'organe de refroidissement.

Ces caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un véhicule électrique de transport, tel qu'un véhicule ferroviaire, comprenant une chaîne de traction, la chaîne de traction comportant un coffre de traction conforme à un exemple de réalisation de l'invention;
- la figure 2 est une représentation schématique plus détaillée du coffre de traction de la figure 1 qui comprend plusieurs dispositifs de commutation conformes à un exemple de réalisation de l'invention ;
- la figure 3 est une représentation schématique plus détaillée de l'un des dispositifs de commutation de la figure 2.

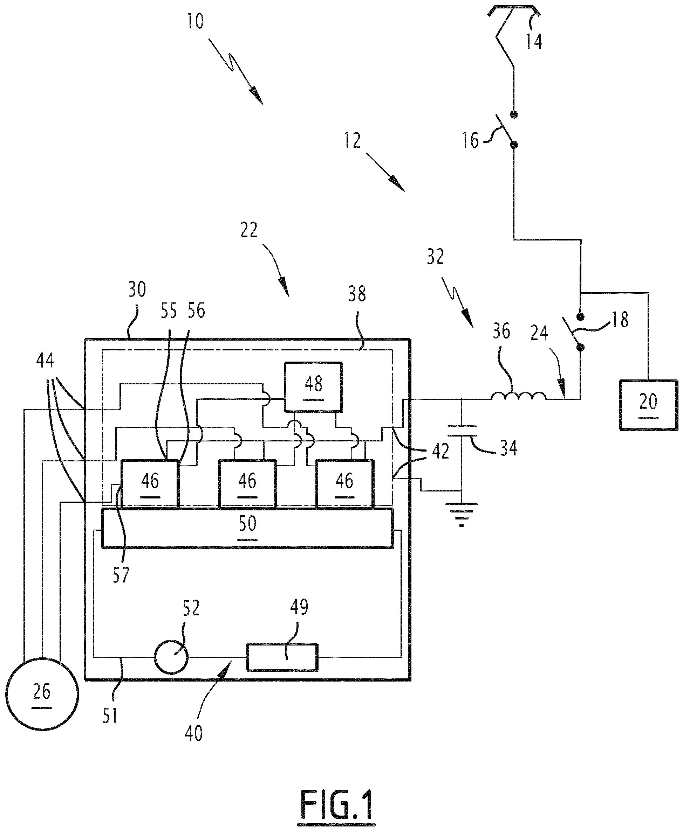

Sur la figure 1, un véhicule électrique de transport 10, tel qu'un véhicule ferroviaire, est représenté de manière schématique.

Le véhicule 10 comprend une chaîne de traction 12.

La chaîne de traction 12 comporte un pantographe 14 apte à être connecté à une caténaire, non représentée, un disjoncteur électrique 16 connecté au pantographe 14 et un commutateur électrique 18 connecté au disjoncteur électrique 16.

La chaîne de traction 12 comprend également un ensemble de traction 22 connecté au commutateur électrique 18 via, par exemple, un bus continu 24.

La chaîne de traction 12 comprend, en complément facultatif, un équipement auxiliaire 20 connecté entre le disjoncteur électrique 16 et le commutateur électrique 18, en dérivation par rapport au commutateur électrique 18.

Le disjoncteur électrique 16, le commutateur électrique 18 et l'équipement auxiliaire 20 sont connus en soi, et ne sont pas décrits plus en détail. L'équipement auxiliaire 20 est par exemple un convertisseur statique.

L'ensemble de traction 22 comporte un moteur électrique 26 et un coffre de traction électrique 30 relié entre le bus continu 24 et le moteur électrique 26. Dans l'exemple de la figure 1, le coffre de traction électrique 30 est destiné à délivrer une tension alternative au moteur 26 à partir d'une tension continue issue du bus continu 24.

En complément, l'ensemble de traction 22 comporte un dispositif de filtrage 32, comportant notamment un condensateur de filtrage 34 et une bobine de filtrage 36.

En complément facultatif, l'ensemble de traction 22 comporte un appareil de stockage d'énergie électrique, non représenté, l'appareil de stockage d'énergie électrique étant également appelé coffre d'autonomie, et servant, d'une part, de source d'alimentation auxiliaire, et d'autre part, à récupérer de l'énergie électrique lors d'un freinage du véhicule électrique de transport 10. L'appareil de stockage d'énergie électrique est, par exemple, connecté en dérivation, entre le commutateur électrique 18 et le condensateur de filtrage 34.

Le moteur électrique 26 est, par exemple, un moteur alternatif, tel qu'un moteur triphasé.

Le moteur électrique 26 est, par exemple, positionné sur un bogie, non représenté, du véhicule 10.

Le coffre de traction électrique 30 est, par exemple, positionné en toiture du véhicule 10.

Le coffre de traction électrique 30 comprend, par exemple, un module électrique de puissance tel qu'un convertisseur d'énergie électrique 38 configuré pour convertir une première énergie électrique en une deuxième énergie électrique et un dispositif 40 de refroidissement du convertisseur d'énergie électrique 38.

Le convertisseur d'énergie électrique 38 est, par exemple, configuré pour convertir une énergie continue associée au bus continu 24 en une énergie alternative, telle qu'une énergie triphasée, associée au moteur électrique 26. La première énergie électrique est alors l'énergie continue, et la deuxième énergie électrique est l'énergie alternative, telle que l'énergie triphasée.

Le convertisseur d'énergie électrique 38 comprend deux premières bornes 42 associées à la première énergie électrique, et au moins une deuxième borne 44 associée à la deuxième énergie électrique, et P dispositif de commutation 46, P étant un nombre entier supérieur ou égal à 1.

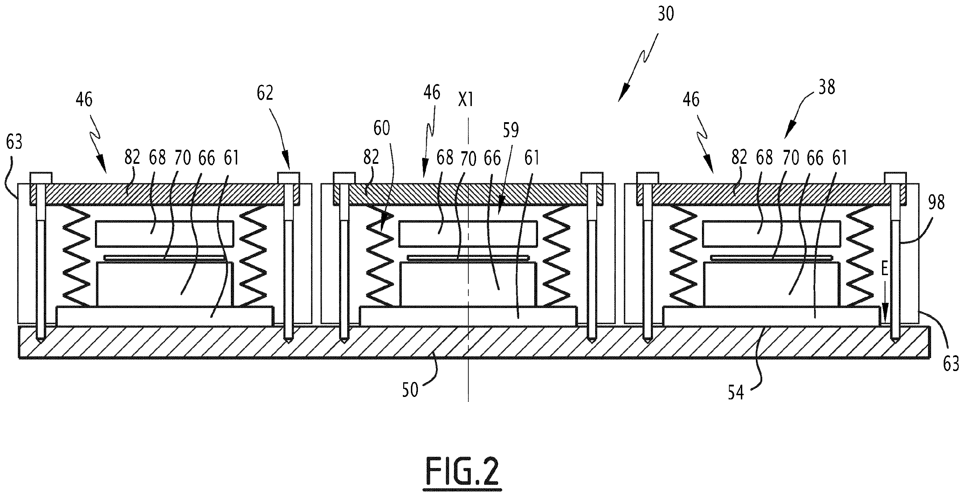

Dans l'exemple des figures 1 et 2, le convertisseur d'énergie électrique 38 est un convertisseur d'énergie continue en énergie alternative triphasée, et comprend alors trois deuxièmes bornes 44 et trois dispositifs de commutation 46, à savoir une deuxième borne 44 et un dispositif de commutation 46 pour chaque phase de l'énergie triphasée.

Avantageusement le convertisseur d'énergie électrique 38 comprend un dispositif 48 de contrôle de chaque dispositif de commutation 46.

Le dispositif de refroidissement 40 comprend un échangeur thermique 49 et un organe 50 de refroidissement de chaque dispositif de commutation.

Le dispositif de refroidissement 40 comprend également un circuit 51 de refroidissement s'étendant entre l'échangeur thermique 49 et l'organe de refroidissement 50.

L'organe de refroidissement 50 est, par exemple, une plaque à eau propre à être en contact avec les dispositifs de commutation 46. En variante, l'organe de refroidissement est un dissipateur thermique, tel qu'un radiateur ou un refroidisseur diphasique.

Avantageusement, le dispositif de refroidissement comprend également une pompe 52 propre à faire circuler un fluide caloriporteur dans le circuit de refroidissement 51 et à travers l'organe de refroidissement 50 et l'échangeur thermique 49.

Le coffre de traction électrique 30 comprend un matériau d'interface thermique sec 54, par exemple sous la forme d'une plaque 54, propre à améliorer le couplage thermique entre chaque dispositif de commutation 46 et le dispositif de refroidissement 40. Le matériau d'interface thermique sec est par exemple un matériau à base de graphite.

Chaque plaque 54, est positionnée entre chaque dispositif de commutation 46 et l'organe de refroidissement 50.

Chaque dispositif de commutation 46 comprend au moins une borne d'entrée 55 propre à être reliée au bus continu 24 via l'une des premières bornes 42.

Avantageusement, chaque dispositif de commutation 46 comprend également une borne de contrôle 56 propre à être connectée au dispositif de contrôle 48.

Chaque dispositif de commutation 46 comprend également une borne de sortie 57 propre à être connectée respectivement à l'une des deuxièmes bornes 44.

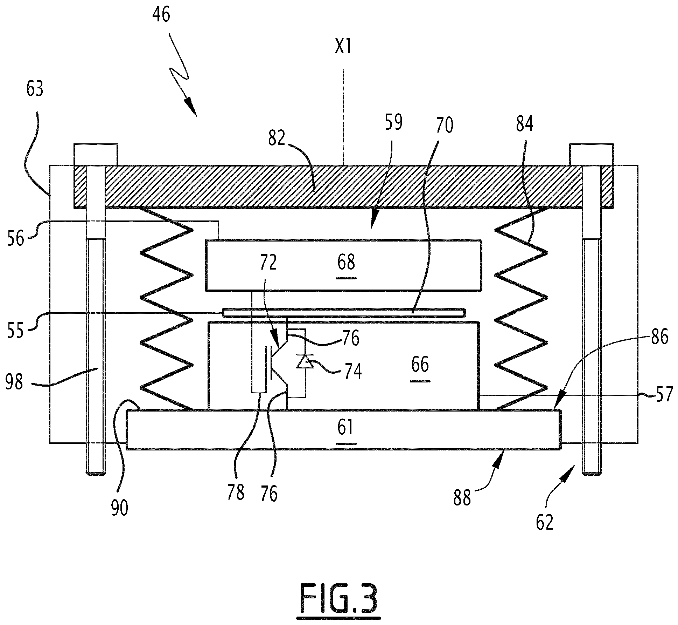

Comme représenté plus en détails sur les figures 2 et 3, chaque dispositif de commutation 46 comprend un ensemble électrique 59, un système 60 de mise en pression de l'ensemble électrique 59, une embase 61 de réception de l'ensemble électrique, et un système 62 de fixation dans le coffre de traction 30.

Avantageusement, chaque dispositif de commutation 46 forme un élément remplaçable du convertisseur d'énergie électrique 38 et comporte un boîtier 63 comprenant l'ensemble électrique 59, le système de mise en pression 60 et l'embase 61.

Avantageusement, l'ensemble électrique 59, et l'embase 61 sont positionnés l'un au-dessus de l'autre suivant un axe X1 perpendiculaire à l'organe de refroidissement 50 lorsque le dispositif de commutation 46 est fixé dans le coffre de traction 30.

L'ensemble électrique 59 comprend au moins un élément de commutation électrique 66, une unité 68 de commande de l'élément de commutation 66 et des moyens de liaison électrique 70.

Avantageusement, lorsque l'ensemble électrique 59 comprend plusieurs éléments de commutation 66, l'ensemble électrique 59 comprend une unité de commande 68 pour chaque élément de commutation 66.

Avantageusement encore, l'élément de commutation 66 et l'embase 61 forment une seule pièce et/ou l'embase 61 appartient à un boîtier recevant l'élément de commutation 66 et avantageusement également l'unité de commande 68 et les moyens de liaison électrique 70.

Dans l'exemple des figures 2 et 3, chaque ensemble électrique 59 comprend un seul élément de commutation 66.

Dans la suite de la description un seul élément de commutation 66 sera décrit étant donné que les éléments de commutation 66 sont de préférence tous identiques.

L'élément de commutation 66 est fixé à l'embase 61 correspondante.

L'élément de commutation 66 également appelé interrupteur est, par exemple, un interrupteur bidirectionnel. Chaque élément de commutation 66 est de préférence un interrupteur bidirectionnel.

Lorsque tous les interrupteurs 66 sont bidirectionnels, le convertisseur d'énergie électrique 38 est alors un convertisseur bidirectionnel configuré pour convertir la première énergie électrique en la deuxième énergie électrique si le courant circule depuis les premières bornes 42 vers la ou les deuxièmes bornes 44, et inversement configuré pour convertir la deuxième énergie électrique en la première énergie électrique si le courant circule depuis la ou les deuxièmes bornes 44 vers les premières bornes 42.

Ce fonctionnement du convertisseur d'énergie électrique 38 en inverse pour convertir la deuxième énergie électrique en la première énergie électrique est notamment utile pour récupérer de l'énergie lors d'un freinage du véhicule électrique de transport 10.

Comme représenté de manière très schématique sur la figure 3, l'élément de commutation 66 comporte, par exemple, un composant semi-conducteur commandable de commutation 72 et une diode 74 connectée en antiparallèle du composant semi-conducteur commandable de commutation 72. Comme connu en soi, chaque composant semi-conducteur commandable de commutation 72 comporte deux électrodes de conduction 76 et une électrode de commande 78, chaque composant semi-conducteur commandable de commutation 72 étant commandable, via son électrode de commande 78, entre un état parmi un état passant dans lequel le courant circule entre les électrodes de conduction 76, et un état bloqué dans lequel le courant ne circule pas entre les électrodes de conduction 76. La diode 74 est alors connectée entre les électrodes de conduction 76.

Le composant semi-conducteur commandable de commutation 72 est par exemple un transistor bipolaire à grille isolée.

L'unité de commande 68, également appelée allumeur, est configurée pour commander l'élément de commutation 66.

L'unité de commande 68 est connectée à l'électrode de commande 78 correspondante.

L'unité de commande 68 est, par exemple, réalisée sous forme d'un composant logique programmable, tel qu'un FPGA (de l'anglais *Field-Programmable Gate Array).*

L'unité de commande 68 est reliée électriquement à la borne de contrôle 56. En d'autres termes, l'unité de commande 68 est propre à être reliée au dispositif de contrôle 48 via la borne de contrôle 56.

Les moyens de liaison électrique 70 sont configurés pour relier l'élément de commutation 66 entre la borne d'entrée 55 et la borne de sortie 57.

Les moyens de liaison électrique 70 forme au moins un jeu de barres, également appelé barre omnibus ou bus barre.

Le système de mise en pression 60 comprend un élément 82 de support de l'ensemble électrique 59 et des moyens 84 de mise en pression de l'ensemble électrique 59 qui s'étendent entre l'élément de support 82 et l'embase 61 et sont configurés pour exercer un effort d'appui E sur l'embase 61 propre à maintenir l'embase en appui contre le dispositif de refroidissement 40 lorsque l'ensemble électrique 59 est intégré/fixé dans le coffre de traction 30.

L'embase 61 est destinée à être positionnée entre l'ensemble électrique 56 et le dispositif de refroidissement 40, plus précisément l'organe de refroidissement 50, lorsque l'ensemble électrique 56 est intégré dans le coffre de traction 30.

L'embase 61 comprend une première face 86 configurée pour être en contact avec l'élément de commutation 66 et une deuxième face 88, opposée à la première face 86, configurée pour être en contact avec l'organe de refroidissement 50.

L'embase 61 comprend autour de l'élément de commutation 66, de préférence autour de l'ensemble électrique 59, une zone de mise en pression 90 en contact avec les moyens de mise en pression 84.

Plus généralement, l'embase 61 correspond, par exemple, à une paroi d'un boîtier recevant l'élément de commutation 66 et avantageusement également l'unité de commande 68 et les moyens de liaison électrique 70.

La zone de mise en pression 90 est située sur la première face 86 et s'étend globalement parallèlement à un plan perpendiculaire à une direction de l'effort d'appui E.

La zone de mise en pression 90 est positionnée sur le pourtour de l'embase 61 par rapport à l'ensemble électrique 59 qui a une position centrale sur l'embase 61.

Les moyens de mise en pression 84 sont régulièrement répartis autour de l'élément de commutation 66, et de préférence de l'ensemble électrique 59.

Les moyens de mise en pression 84 s'étendent suivant la direction de l'effort d'appui E et sont, par exemple, formés par des ressorts hélicoïdaux.

En variante, les moyens de mise en pression 84 sont, par exemple, formés par des ressorts ondulés à fils plats ou des rondelles Belleville.

Le système de fixation 62 est configuré pour maintenir l'élément de support 82 dans une position prédéterminée par rapport au dispositif de refroidissement 40.

Avantageusement, le système de fixation 62 est configuré pour fixer l'élément de support 82 à l'organe de refroidissement 50 de manière amovible.

Le système de fixation 62 comprend, par exemple, des vis 98 propres à traverser l'élément de support 82 et avantageusement le boîtier 63 et à être reçues dans des orifices de fixation ménagés dans l'organe de refroidissement 50. En variante, le système de fixation comprend, par exemple, des vis quart de tours ou des grenouillères.

Avantageusement, les vis 98 sont positionnées parallèlement à l'axe X1 sur l'extérieur du dispositif de commutation 46 par rapport à l'ensemble électrique 59 et aux moyens de mise en pression 84 suivant le plan perpendiculaire à la direction de l'effort d'appui E.

Le système de fixation 62 permet une fixation amovible de chaque dispositif de commutation 46 dans le coffre de traction 30 et notamment une fixation amovible de chaque dispositif de commutation 46 à l'organe de refroidissement 50.

Par ailleurs, le système de fixation 62 permet d'intégrer facilement chaque dispositif de commutation 46 dans le convertisseur 38 et donc de modifier la configuration du convertisseur 38 de manière simplifiée.

De plus, le fait que chaque dispositif de commutation 46 forme un élément remplaçable permet de simplifier la maintenance du coffre de traction 30.

En outre, le fait d'utiliser plusieurs dispositifs de commutation 46 afin de former un convertisseur électrique 38 et de dissocier la fonction refroidissement de la fonction commutation permet également de simplifier la maintenance du coffre de traction 30.

Plus précisément, il n'est pas nécessaire de manipuler l'ensemble du coffre de traction 30 et l'organe de refroidissement 50 lorsqu'un défaut électrique apparait au niveau du convertisseur électrique 38. Il suffit de repérer le dispositif de commutation 46 en défaut et de le remplacer.

Par ailleurs, le poids de chaque dispositif de commutation 46 est minimisé de sorte qu'ils sont manipulables par un seul opérateur sans que cela ne nécessite l'utilisation d'outillages dédiés à la manipulation de charges lourdes.

En outre, l'utilisation d'un matériau d'interface thermique sec permet à la fois de retirer/installer facilement le dispositif de commutation 46 dans le convertisseur 38, c'est-à-dire dans le coffre de traction 30, et d'améliorer les échanges thermiques entre le dispositif de commutation 46 et l'organe de refroidissement 50.

Avantageusement, l'embase 61 a une forme ou une composition optimisée de sorte qu'elle favorise les échanges thermiques entre l'élément de commutation 66 et l'organe de refroidissement 50.

Par ailleurs, le fait que les moyens de mise en pression 84 soient régulièrement répartis autour de l'ensemble électrique 59 sur un pourtour de l'embase 61 permet de mieux répartir l'effort de pression E et donc d'optimiser le contact entre l'embase 61 et l'organe de refroidissement 50, c'est-à-dire d'optimiser les échanges thermiques entre le dispositif de commutation 46, notamment l'ensemble électrique 59, et le dispositif de refroidissement 40.

En outre, dans l'exemple du moteur triphasé 26, il est possible d'utiliser trois dispositifs de commutation 46 identiques, c'est-à-dire standardisés, pour réaliser la fonction de conversion électrique. Cela permet de réduire les coûts de fabrication et de maintenance du coffre de traction 30.

Plus généralement, l'utilisation de dispositifs de commutation 46 standardisés permet d'offrir un coffre de traction 30 dont le convertisseur 38 a une configuration modulable grâce à l'ajout ou au retrait de dispositifs de commutation 46.

Enfin le fait d'avoir l'ensemble électrique 59 a une position centrale sur l'embase 61, les moyens de mise en pression 84 disposés autour de l'ensemble électrique et qui s'étendent entre un pourtour de l'embase 61 et l'élément de support 82 et les vis 98 situées sur l'extérieur du dispositif de commutation 46 permet de séparer les fonctions électriques liées à l'ensemble électrique 59, des fonctions de mise en pression de l'ensemble électrique 59 contre l'organe de refroidissement 50 et des fonctions de fixation du dispositif de commutation 46 dans le coffre de traction 30 à l'organe de refroidissement 50. Ainsi, chaque élément du dispositif de commutation 46 peut être configuré afin de réaliser la fonction à laquelle il est dédié de manière optimale, c'est-à-dire que l'ensemble électrique 59 n'a par exemple pas besoin d'être configuré pour supporter l'effort de pression puisque l'effort de pression est appliqué sur l'embase 61. En outre, cette disposition du système de fixation 62 et du système de mise en pression 60 permet d'optimiser le contact entre l'embase 61 et l'organe de refroidissement 50 et donc le refroidissement de l'ensemble électrique 59.

Les modes de réalisation et variantes envisagés ci-dessus sont propres à être combinés entre eux pour donner lieu à d'autres modes de réalisation de l'invention.

## Revendications

1. Dispositif de commutation électrique (46) d'un module électrique de puissance (38) propre à être intégré dans un coffre de traction électrique (30) d'un véhicule de transport (10), le coffre de traction (30) comprenant un dispositif de refroidissement (40) propre à refroidir le dispositif de commutation, le dispositif de commutation comprenant :
- un ensemble électrique (59) muni d'un élément de commutation électrique (66), et
- un système (60) de mise en pression de l'ensemble électrique (59) comprenant un élément (82) de support de l'ensemble électrique et des moyens (84) de mise en pression de l'ensemble électrique (59),
**caractérisé en ce que** le dispositif de commutation (46) comprend une embase (61) de réception de l'ensemble électrique (59), l'embase (61) étant destinée à être positionnée entre l'ensemble électrique (59) et le dispositif de refroidissement (40) lorsque le dispositif de commutation est intégré dans le coffre de traction, et **en ce que** les moyens de mise en pression (84) s'étendent entre l'élément de support (82) et l'embase (61) et sont configurés pour exercer un effort d'appui (E) sur l'embase propre à maintenir l'embase en appui contre le dispositif de refroidissement (40) lorsque le dispositif de commutation est intégré dans le coffre de traction.

2. Dispositif de commutation électrique selon la revendication 1, dans lequel le dispositif de commutation (46) comprend un système (62) de fixation dans le coffre de traction (30), le système de fixation (62) étant propre à maintenir l'élément de support (82) dans une position prédéterminée par rapport au dispositif de refroidissement (40).

3. Dispositif selon la revendication 2, dans lequel le système de fixation (62) est propre à fixer de manière amovible le dispositif de commutation (46) au dispositif de refroidissement (40).

4. Dispositif de commutation selon l'une quelconque des revendications précédentes, dans lequel le dispositif de commutation (46) comprend un boîtier (63) comprenant l'ensemble électrique (59), le système de mise en pression (60) et l'embase (61).

5. Dispositif de commutation selon l'une quelconque des revendications précédentes, dans lequel l'ensemble électrique (59) est muni d'une unité de commande (68) de l'élément de commutation (66) et de moyens de liaison électrique (70).

6. Dispositif selon l'une quelconque des revendications précédentes, dans lequel l'élément de commutation (66) est fixé à l'embase (61), et dans lequel l'embase (61) comprend autour de l'élément de commutation (66), de préférence de l'ensemble électrique (59), au moins une zone de mise en pression (90) en contact avec les moyens de mise en pression (84), la zone de mise en pression (90) s'étendant globalement parallèlement à un plan perpendiculaire à une direction de l'effort d'appui (E).

7. Dispositif selon l'une quelconque des revendications précédentes, dans lequel les moyens de mise en pression (84) sont régulièrement répartis autour de l'élément de commutation (66), et de préférence de l'ensemble électrique (59).

8. Coffre de traction électrique (30) d'un véhicule de transport (10), **caractérisé en ce que** le coffre de traction (30) comprend :
- un module électrique de puissance (38) comprenant au moins un dispositif de commutation (46) selon l'une quelconques des revendications 1 à 7, et
- un dispositif de refroidissement (40) propre à refroidir chaque dispositif de commutation (46).

9. Coffre selon la revendication 8, dans lequel un matériau d'interface thermique sec (54), propre à améliorer le couplage thermique entre chaque embase (61) et le dispositif de refroidissement (40), est positionné entre chaque embase (61) et le dispositif de refroidissement (40).

10. Coffre selon la revendication 8 ou 9, dans lequel le dispositif de refroidissement (40) comprend un échangeur thermique (49), un organe de refroidissement (50) de chaque dispositif de commutation (46), l'organe de refroidissement (50) étant en contact avec chaque embase (61) de chaque dispositif de commutation et un circuit de refroidissement (51) s'étendant entre l'échangeur thermique (49) et l'organe de refroidissement (50).
